# EUROPEAN PATENT SPECIFICATION

(11) **EP 3 751 864 B1**
(45) Date of publication and mention of the grant of the patent: **05.08.2026**
(21) Application number: 19750943.3
(22) Date of filing: 02.02.2019
(51) Int. Cl.: H04R 1/02, H04R 9/00, H05K 7/20

(54) **LOUDSPEAKER ASSEMBLY AND ELECTRONIC DEVICE**
LAUTSPRECHERANORDNUNG UND ELEKTRONISCHE VORRICHTUNG
ENSEMBLE HAUT-PARLEUR ET DISPOSITIF ÉLECTRONIQUE

(30) Priority: 11.02.2018 CN 201810140877
(43) Date of publication of application: 16.12.2020
(73) Proprietor: Vivo Mobile Communication Co., Ltd., Dongguan, Guangdong 523860 (CN)
(72) Inventor: CAI, Qiong, Dongguan, Guangdong 523860 (CN); LI, Junwen, Dongguan, Guangdong 523860 (CN)
(74) Representative: Lavoix
(86) International application number: PCT/CN2019/074565
(87) International publication number: WO 2019/154359

(56) References cited:
- WO-A1-2011/045894
- WO-A1-2017/041514
- CN-A- 105 592 389
- CN-A- 106 454 663
- CN-A- 108 391 188
- CN-U- 204 906 708
- CN-U- 205 622 852
- CN-U- 206 136 253
- US-A1- 2004 071 309
- US-A1- 2006 239 487

## Description

### TECHNICAL FIELD

The present disclosure relates to the field of communication technologies, in particular to a loudspeaker assembly and an electronic device.

### BACKGROUND

A loudspeaker assembly is an important electroacoustic transduction component in an electronic device with audio playback functions, such as a speaker box, a cell phone, or an earphone. In a conventional loudspeaker assembly of an electronic device, a loudspeaker unit is assembled into an enclosed housing to form a BOX assembly. The interior of the housing is divided into a front housing cavity and a rear housing cavity by a separator member and the loudspeaker unit. A balance hole is opened on a side wall of the housing at a location corresponding to the rear housing cavity. The airflow internal to the rear housing cavity needs to be exchanged with the airflow internal to the electronic device through the balance hole, and then with the atmosphere external to the electronic device through slits on the electronic device, so as to allow air-pressure balance and heat dissipation of the rear housing cavity. However, as the sealing of conventional electronic devices improves, the exchange between the airflow internal to the electronic device and the atmosphere external to electronic device is hampered, leading indirectly to hampered exchange between the airflow in the rear housing cavity and the atmosphere external to the electronic device, which causes poor ventilation in the rear housing cavity, and consequently causes the problem of air-pressure imbalance and poor heat dissipation in the rear housing cavity which degrades the performance of the loudspeaker assembly.

CN 106454663A relates to a loudspeaker module. The loudspeaker module comprises a module housing and a loudspeaker single body received in the module housing. The module cavity enclosed by the module housing is separated to two cavities of a front vocal cavity and a back vocal cavity by the loudspeaker single body. The module cavity is internally provided with a baffle for separating the front vocal cavity and the back vocal cavity. The baffle is provided with a pressure-releasing channel communicated with the front vocal cavity and the back vocal cavity and sealed acoustically.

US 2006/239487A1 relates to methods and structures for providing a simulated rock speaker cabinet. The simulated rock speaker includes a hollow casing having an interior surface, an exterior surface, and at least one port extending through and between the interior and exterior surfaces. WO 2011/045894 describes an electronic device such as a mobile phone with a casing, signal converter, through hole, openings and waterproof films.

### SUMMARY

In embodiments of the present disclosure, a loudspeaker assembly and an electronic device are provided, to solve the problem in the related art of air-pressure imbalance and poor heat dissipation in the rear housing cavity due to poor ventilation in the rear housing cavity.

This invention is defined in the appended set of claims.

In the loudspeaker assembly according to an embodiment of the present disclosure, a balance hole is opened on the separator inside the housing, so that the rear housing cavity (i.e., the second cavity) can communicate with the exterior of the electronic device through the front housing cavity (i.e. the first cavity) to allow air exchange, thereby ensuring the air-pressure balance and heat dissipation in the rear housing cavity and consequently ensuring the performance of the loudspeaker assembly.

### BRIEF DESCRIPTION OF THE DRAWINGS

In order to explain the technical solutions in the embodiments of the present disclosure more clearly, the drawings required in description of the embodiments of the present disclosure will be briefly described below. Apparently, the drawings in the following description illustrate merely some embodiments of the present disclosure, and other drawings can be obtained based on these drawings without any creative effort by those of ordinary skill in the art.
Fig. 1 illustrates a first sectional view of a loudspeaker assembly according to an embodiment of the present disclosure;
Fig. 2 illustrates a second sectional view of a loudspeaker assembly according to an embodiment of the present disclosure; and
Fig. 3 illustrates a third sectional view of a loudspeaker assembly according to an embodiment of the present disclosure.

### DETAILED DESCRIPTION

The technical solutions in the embodiments of the present disclosure will be described clearly and completely below with reference to the drawings in the embodiments of the present disclosure.

In an aspect of embodiments of the present disclosure, a loudspeaker assembly, in particular a side sound-emission loudspeaker assembly, is provided.

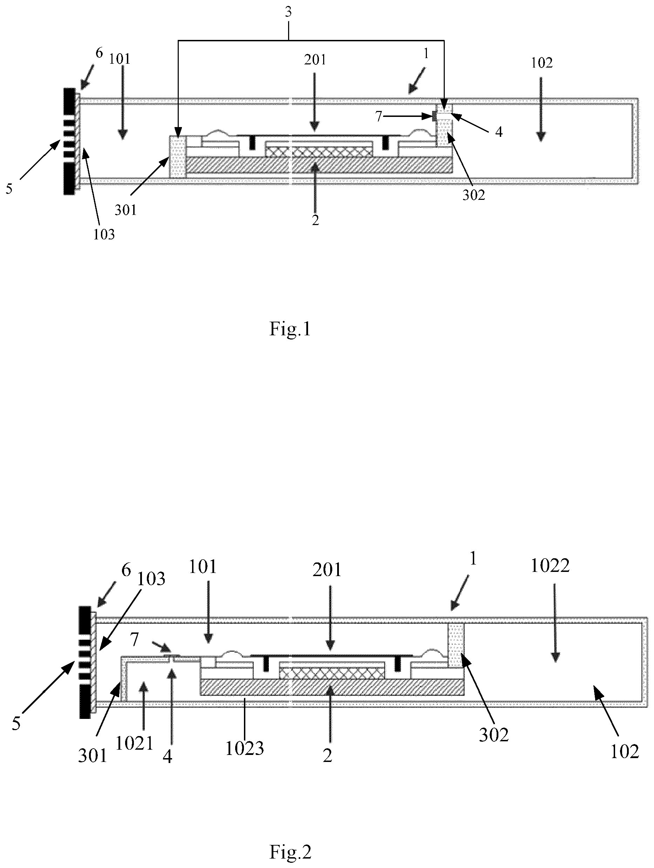

As shown in Fig. 1 to Fig. 3, the loudspeaker assembly includes a housing 1 and a loudspeaker unit 2 provided in the housing 1.

An internal cavity is formed inside the housing 1. The loudspeaker unit 2 is built in the internal cavity. A separator 3 is also provided in the internal cavity. The internal cavity is divided by the separator 3 and the loudspeaker unit 2 into a first cavity 101 (corresponding to a front cavity of the housing 1) and a second cavity 102 (corresponding to a rear cavity of the housing 1).

A loudspeaker diaphragm in the loudspeaker unit 2 is positioned in the first cavity 101. The housing 1 has through hole 103, the first cavity 101 communicates with an exterior of the housing 1 by the through hole 103. The first cavity 101 forms a sound-emission channel, and the sound emitted from the loudspeaker unit 2 passes through the first cavity 101 to propagate out of the electronic device via the through hole 103 on the housing 1. Typically, the through hole 103 on the housing 1 is arranged opposite to a sound-outlet hole 5 on the electronic device, so as to enable better outward propagation of sound. To prevent dust from entering the electronic device via the sound-outlet hole 5, a dust screen 6 is also provided on the inner side of the sound-outlet hole 5.

In an embodiment of the present disclosure, to ensure air-pressure balance and heat dissipation in the second cavity 102, a balance hole 4 in communication with the first cavity 101 is opened on the separator 3. The second cavity 102 is in communication with the first cavity 101 via the balance hole 4.

As the first cavity 101 can communicate with the exterior of the electronic device by the through hole 103 on the housing 1, the second cavity 102 can also communicate with the exterior of the electronic device indirectly through the first cavity 101. In this way, better air-pressure balance and heat dissipation in the second cavity 102 is ensured, without having to exchange air with the airflow internal to the electronic device through the balance hole 4 and then with the atmosphere external to the electronic device through slits on the electronic device.

The balance hole 4 is covered with a water-proof membrane 7, so as to prevent external water from entering the second cavity 102 as well as control the amount of air allowed into the second cavity 102.

Specifically, as shown in Fig. 1 to Fig. 3, the separator 3 includes a first separator member 301 and a second separator member 302.

The first separator member 301 has a first end attached to an inner side wall of the housing 1 facing away from the loudspeaker diaphragm, and a second end attached to the loudspeaker unit 2. The second separator member 302 has a first end attached to an inner side wall of the housing 1 facing the loudspeaker single diaphragm, and a second end attached to the loudspeaker unit 2. In this way, the first separator member 301, the second separator member 302, and the loudspeaker unit 2 divide the internal cavity of the housing 1 into a first cavity 101 and a second cavity 102.

The balance hole 4 is provided on the first separator member 301 and the second separator member 302, and a specific configuration thereof may be designed according to practical requirements. The embodiments shown in Figs. 1 and 2 are not encompassed by the wording of the claims but are considered as useful for understanding the invention

Specifically, Fig. 1 is a schematic view of a structure in which the balance hole 4 is opened only on the second separator member 302. In this case, the second separator member 302 may keep its original structure and shape, or preferably has the L-shaped structural section similar to the first separator member 301 as shown in Fig. 2, or may be designed according to practical requirements, and no limitation is made in this respect in embodiments of the present disclosure.

Specifically, Fig. 2 is a schematic view of a structure in which the balance hole 4 is only opened on the first separator member 301. In this case, the loudspeaker unit 2 divides the second cavity 102 into a first sub-cavity 1021 and a second sub-cavity 1022.

It can be seen from Fig. 1 that, a lower end face of the loudspeaker unit 2 is close to the inner side wall of the housing 1. To ensure that there is sufficient space on the first separator member 301 to open the balance hole 4, the first sub-cavity 1021 is formed between the first separator member 301, the inner side wall of the housing 1, and the loudspeaker unit 2, and the second sub-cavity 1022 is formed between the loudspeaker unit 2, the second separator member 302, and the inner side wall of the housing 1. The first sub-cavity 1021 is in communication with the second sub-cavity 1022 through a communication channel 1023.

In terms of the structure and shape, the first separator member preferably has the L-shaped structure shown in the drawings. The balance hole 4 may be provided on the horizontal surface of the first separator member 301, or on the vertical surface of the first separator member 301.

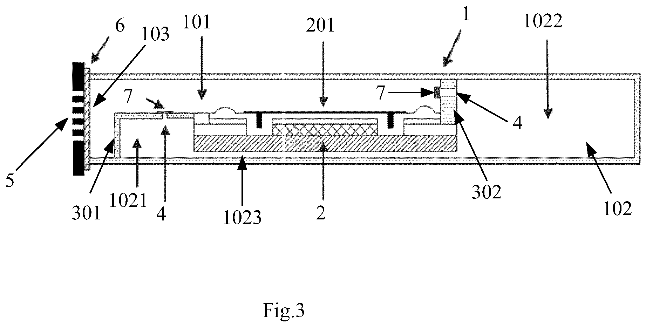

Specifically, Fig. 3 is a schematic view of a structure in which the balance hole 4 is opened on both the first separator member 301 and the second separator member 302. Of course, in terms of the structure and shape, the first separator member 301 may preferably have the L-shaped structure shown in the drawings.

Further, the first separator member 301 and the second separator member 302 are injection molded structures, thereby a molding process thereof is simple and cost is low.

In summary, in the loudspeaker assembly according to an embodiment of the present disclosure, a balance hole 4 is opened on the separator inside the housing 1, so that the rear cavity of the housing 1 (i.e., the second cavity 102) can communicate with the exterior of the electronic device through the front cavity of the housing 1 (i.e., the first cavity 101) to allow air exchange, thereby ensuring the air-pressure balance and heat dissipation in the rear cavity of the housing 1 and consequently ensuring the performance of the loudspeaker assembly.

In another aspect of embodiments of the present disclosure, an electronic device including the foregoing loudspeaker assembly is provided.

A sound-outlet hole 5 is opened on the casing of the electronic device, and the through hole 103 on the housing 1 of the loudspeaker assembly is arranged opposite to the sound-outlet hole 5.

The electronic device according to an embodiment of the present disclosure includes, without limitation, a cell phone, a tablet computer, a personal digital assistant, a speaker box, an earphone, and the like.

In the loudspeaker assembly of the electronic device according to an embodiment of the present disclosure, a balance hole 4 is opened on the separator inside the housing 1, so that the rear cavity of the housing 1 (i.e., the second cavity 102) can communicate with the exterior of the electronic device through the front cavity of the housing 1 (i.e. the first cavity 101) to allow air exchange, thereby ensuring the air-pressure balance and heat dissipation in the rear cavity of the housing 1 and consequently ensuring the performance of the loudspeaker assembly.

In the description of the present disclosure, it should be understood that the orientational or positional relationships denoted by the terms "central", "longitudinal", "transversal", "length", "width", "thickness", "upper", "lower", "front", "rear", "left", "right", "vertical"", "horizontal", "top", "bottom", "inner", and "exterior" are orientational or positional relationships based on the drawings, and are merely for ease and simplicity of description of the present disclosure and are not intended to indicate or imply that the device or element referred to must have a particular orientation or be constructed and operated in a particular orientation; and therefore should not be understood as limitation on the present disclosure.

In the description of the present disclosure, the term "a plurality of" means at least two, e.g., two, three, etc., unless otherwise specifically defined.

In the present disclosure, unless otherwise specified and defined, the terms such as "installed", "connected", "attached" and "fixed" should be understood in a broad sense, for example, they can refer to a fixed connection, a detachable connection or integration; they can be mechanical connection, electrical connection or communication with each other; they can be direct connection or indirect connection via an intermediate medium, or can be internal communication between two elements or interaction between two elements. For those of ordinary skill in the art, the specific meanings of the above terms in the present disclosure can be derived according to specific situations.

In this disclosure, unless otherwise explicitly specified and defined, the expression that a first feature is "on" or "under" a second feature may mean direct contact between the first and second features, or may mean indirect contact between the first and second features via another feature. Furthermore, the expression that a first feature "above", "on", or "on top of" a second feature means that the first feature is directly above or obliquely above the second feature, or simply means that the first feature is higher in level than the second feature. The expression that the first feature is "below", "under", or "beneath" the second feature means that the first feature is directly below or obliquely below the second feature, or simply means that the first feature is lower in level than the second feature.

All the embodiments in this specification are described in a progressive way, and each embodiment focuses on the differences from other embodiments. The same and similar parts among the embodiments can be referred to each other.

Although preferred embodiments of the embodiments of the present disclosure have been described, those skilled in the art can make additional changes and modifications to these embodiments based on the basic inventive concepts.

Therefore, the scope of protection is defined by the claims.

Finally, it should be noted that in this specification, relational terms such as "first" and "second" are intended merely to distinguish one entity or operation from another entity or operation, and do not necessarily require or imply any such actual relationship or order between these entities or operations. Furthermore, the terms "including", "include" or any other variant thereof are intended to cover non-exclusive inclusion, so that a process, method, article or terminal device including a series of elements includes not only those elements, but also other elements not explicitly listed, or elements inherent to such a process, method, article or terminal device. Without further restrictions, the elements defined by the expression "including one ..." do not exclude the presence of other identical elements in the process, method, article or terminal device including the elements.

Described above are preferred embodiments of the present disclosure.

## Claims

1. A loudspeaker assembly, applied to an electronic device, **characterized by** the loudspeaker assembly comprising:
a housing (1) having an internal cavity;
a loudspeaker unit (2) built in the internal cavity and including a loudspeaker diaphragm; and
a separator (3) provided in the internal cavity, the internal cavity being divided by the separator (3) and the loudspeaker unit (2) into a first cavity (101) and a second cavity (102);
wherein the housing (1) has a through hole (103), the first cavity (101) communicates with an exterior of the housing (1) by the through hole (103), and the loudspeaker diaphragm is positioned in the first cavity (101); and the separator (3) is provided with a balance hole (4) in communication with the first cavity (101), and the second cavity (102) is in communication with the first cavity (101) through the balance hole (4);
wherein the separator (3) comprises a first separator member (301) and a second separator member (302), the balance hole (4) comprises a first balance hole and a second balance hole which are provided on the first separator member (301) and the second separator member (302), respectively, wherein both the first balance hole and the second balance hole are covered with a water-proof membrane (7) to control the amount of air allowed into the second cavity (102);
the first separator member (301) has a first end attached to an inner side wall of the housing (1) facing away from the loudspeaker diaphragm, and the first separator member (301) has a second end attached to the loudspeaker unit (2); and
the second separator member (302) has a first end attached to an inner side wall of the housing (1) facing the loudspeaker diaphragm, and the second separator member (302) has a second end attached to the loudspeaker unit (2);
wherein the loudspeaker unit (2) divides the second cavity (102) into a first sub-cavity (1021) and a second sub-cavity (1022), and the first sub-cavity (1021) communicates with the second sub-cavity (1022) through a communication channel (1023).

2. The loudspeaker assembly according to claim 1, wherein the first separator member (301) and the second separator member (302) are injection molded structures.

3. The loudspeaker assembly according to claim 1, wherein the first separator member (301) and/or second separator member (302) has an L shape.

4. The loudspeaker assembly according to claim 1, wherein the loudspeaker assembly is a side sound-emission loudspeaker assembly.

5. An electronic device, **characterized by** comprising the loudspeaker assembly according to any one of claims 1 to 4, wherein a sound-outlet hole (5) is opened on a casing of the electronic device, and the through hole (103) on the housing (1) of the loudspeaker assembly is arranged opposite to the sound-outlet hole (5).

## Patentansprüche

1. Eine Lautsprechereinheit, angebracht an einem elektronischen Gerät, **dadurch gekennzeichnet, dass** die Lautsprechereinheit Folgendes umfasst:
ein Gehäuse (1) mit einer inneren Kavität;
eine Lautsprechereinheit (2), die in der inneren Kavität integriert ist und eine Lautsprechermembran umfasst; und
ein Trennelement (3), das in der inneren Kavität angeordnet ist, wobei die innere Kavität durch das Trennelement (3) und die Lautsprechereinheit (2) in eine erste Kavität (101) und eine zweite Kavität (102) unterteilt ist;
wobei das Gehäuse (1) ein Durchgangsloch (103) aufweist, die erste Kavität (101) über das Durchgangsloch (103) mit einem Außenbereich des Gehäuses (1) kommuniziert, und die Lautsprechermembran in der ersten Kavität (101) positioniert ist; und das Trennelement (3) mit einem Ausgleichsloch (4) versehen ist, das mit der ersten Kavität (101) in Verbindung steht, und die zweite Kavität (102) über das Ausgleichsloch (4) mit der ersten Kavität (101) in Verbindung steht;
wobei das Trennelement (3) ein erstes Trennelement (301) und ein zweites Trennelement (302) umfasst, das Ausgleichsloch (4) ein erstes Ausgleichsloch und ein zweites Ausgleichsloch umfasst, die jeweils auf dem ersten Trennelement (301) bzw. dem zweiten Trennelement (302) angeordnet sind, wobei sowohl das erste Ausgleichsloch als auch das zweite Ausgleichsloch mit einer wasserdichten Membran (7) abgedeckt sind, um die Menge an Luft zu regeln, die in die zweite Kavität (102) gelangt;
das erste Trennelement (301) hat ein erstes Ende, das an einer inneren Seitenwand des Gehäuses (1) befestigt ist, die von der Lautsprechermembran abgewandt ist, und das erste Trennelement (301) hat ein zweites Ende, das an der Lautsprechereinheit (2) befestigt ist; und
das zweite Trennelement (302) hat ein erstes Ende, das an einer inneren Seitenwand des Gehäuses (1) befestigt ist, die zur Lautsprechermembran hin liegt, und das zweite Trennelement (302) hat ein zweites Ende, das an der Lautsprechereinheit (2) befestigt ist;
wobei die Lautsprechereinheit (2) die zweite Kavität (102) in eine erste Teilkavität (1021) und eine zweite Teilkavität (1022) unterteilt, und die erste Teilkavität (1021) mit der zweiten Teilkavität (1022) über einen Verbindungskanal (1023) in Verbindung steht.

2. Die Lautsprechereinheit gemäß Anspruch 1, wobei das erste Trennelement (301) und das zweite Trennelement (302) spritzgegossene Strukturen sind.

3. Die Lautsprechereinheit gemäß Anspruch 1, wobei das erste Trennelement (301) und/oder das zweite Trennelement (302) eine L-Form aufweisen.

4. Die Lautsprechereinheit gemäß Anspruch 1, wobei die Lautsprechereinheit eine Lautsprechereinheit mit seitlicher Schallabgabe ist.

5. Ein elektronisches Gerät, **dadurch gekennzeichnet, dass** es die Lautsprechereinheit gemäß einem der Ansprüche 1 bis 4 umfasst, wobei ein Schallauslassloch (5) in einem Gehäuse des elektronischen Geräts angeordnet ist und das Durchgangsloch (103) am Gehäuse (1) der Lautsprechereinheit gegenüber dem Schallauslassloch (5) angeordnet ist.

## Revendications

1. Un ensemble haut-parleur, appliqué à un dispositif électronique, **caractérisé en ce qu'**il comprend :
un boîtier (1) ayant une cavité interne ;
une unité haut-parleur (2) intégrée dans la cavité interne et comprenant une membrane de haut-parleur ; et
un séparateur (3) prévu dans la cavité interne, la cavité interne étant divisée par le séparateur (3) et l'unité haut-parleur (2) en une première cavité (101) et une deuxième cavité (102) ;
dans lequel le boîtier (1) présente un trou traversant (103), la première cavité (101) communique avec l'extérieur du boîtier (1) par le trou traversant (103), et la membrane de haut-parleur est positionnée dans la première cavité (101) ; et le séparateur (3) est prévu avec un trou d'équilibrage (4) en communication avec la première cavité (101), et la deuxième cavité (102) est en communication avec la première cavité (101) par l'intermédiaire du trou d'équilibrage (4) ;
dans lequel le séparateur (3) comprend un premier élément séparateur (301) et un deuxième élément séparateur (302), le trou d'équilibrage (4) comprend un premier trou d'équilibrage et un deuxième trou d'équilibrage qui sont respectivement prévus sur le premier élément séparateur (301) et le deuxième élément séparateur (302), dans lequel le premier trou d'équilibrage et le deuxième trou d'équilibrage sont tous deux recouverts d'une membrane étanche (7) pour contrôler la quantité d'air admise dans la deuxième cavité (102) ;
le premier élément séparateur (301) a une première extrémité fixée à une paroi interne du boîtier (1) orientée à l'opposé de la membrane de haut-parleur, et le premier élément séparateur (301) a une deuxième extrémité fixée à l'unité haut-parleur (2) ; et
le deuxième élément séparateur (302) a une première extrémité fixée à une paroi interne du boîtier (1) orientée vers la membrane de haut-parleur, et le deuxième élément séparateur (302) a une deuxième extrémité fixée à l'unité haut-parleur (2) ;
dans lequel l'unité haut-parleur (2) divise la deuxième cavité (102) en une première sous-cavité (1021) et une deuxième sous-cavité (1022), et la première sous-cavité (1021) communique avec la deuxième sous-cavité (1022) par l'intermédiaire d'un canal de communication (1023).

2. L'ensemble haut-parleur selon la revendication 1, dans lequel le premier élément séparateur (301) et le deuxième élément séparateur (302) sont des structures moulées par injection.

3. L'ensemble haut-parleur selon la revendication 1, dans lequel le premier élément séparateur (301) et/ou le deuxième élément séparateur (302) ont une forme en L.

4. L'ensemble haut-parleur selon la revendication 1, dans lequel l'ensemble haut-parleur est un ensemble haut-parleur à émission sonore latérale.

5. Un dispositif électronique, **caractérisé en ce qu'**il comprend l'ensemble haut-parleur selon l'une quelconque des revendications 1 à 4, dans lequel un trou de sortie sonore (5) est ouvert sur un boîtier du dispositif électronique, et le trou traversant (103) sur le boîtier (1) de l'ensemble haut-parleur est disposé en face du trou de sortie sonore (5).
